# EUROPÄISCHE PATENTSCHRIFT

(11) **EP 1 728 277 B1**
(45) Veröffentlichungstag und Bekanntmachung des Hinweises auf die Patenterteilung: **30.01.2008**
(21) Anmeldenummer: 05716915.3
(22) Anmeldetag: 04.03.2005
(51) Int. Cl.: H01L 23/10, H01L 23/047

(54) **Gehäuse für eine elektronische Schaltung und Verfahren zum Abdichten des Gehäuses**
Housing for an electronic circuit and method for sealing the housing
Boîtier de circuit électronique et procédé d'étanchéification dudit boîtier

(30) Priorität: 16.03.2004 DE 102004013890; 30.04.2004 DE 102004021365
(43) Veröffentlichungstag der Anmeldung: 06.12.2006
(73) Patentinhaber: ROBERT BOSCH GMBH, 70442 Stuttgart (DE)
(72) Erfinder: WETZEL, Gerhard, 70825 Korntal-Muenchingen (DE)
(86) Internationale Anmeldenummer: PCT/EP2005/050974
(87) Internationale Veröffentlichungsnummer: WO 2005/088709

(56) Entgegenhaltungen:
- US-A- 5 107 074
- US-A- 5 943 558

## Beschreibung

Die Erfindung betrifft ein Gehäuse für eine elektronische Schaltung, insbesondere für ein Steuergerät. Die Schaltung weist eine Mehrzahl von elektrischen Kontakten auf, die über individuelle, freiliegende elektronische Leiter (2) nach außerhalb des Gehäuses geführt sind. Das Gehäuse umfasst eine Bodenplatte und einen Deckel sowie mindestens eine Dichtung zwischen der Bodenplatte und dem Deckel.

Die Erfindung betrifft auch ein Verfahren zum Abdichten eines Gehäuses für eine elektronische Schaltung, insbesondere für ein Steuergerät. Die Schaltung weist eine Mehrzahl von elektrischen Kontakten auf, die über individuelle, freiliegende elektrische Leiter nach außerhalb des Gehäuses geführt sind. Das Gehäuse umfasst eine Bodenplatte, einen Deckel und eine Dichtung zwischen der Bodenplatte und dem Deckel.

### Stand der Technik

Gehäuse für eine Getriebesteuerung und Verfahren dieser Art sind im Stand der Technik grundsätzlich bekannt. Diese Gehäuse werden typischerweise an einer Position innerhalb des Getriebes eingebaut, in der sie permanent von Getriebeöl umgeben und einem großen Temperaturbereich, zum Beispiel von -40° Celsius bis +150° Celsius ausgesetzt sind. Zum Schutz der in die Gehäuse eingebauten elektronischen Schaltungen ist es erforderlich, die Gehäuse so auszubilden, dass sie den beschriebenen extremen Umgebungsbedingungen standhalten und insbesondere keine Diffusion des Öls oder von dessen Bestandteilen in das Innere des Gehäuses möglich ist. Kunststoff- oder Metallteile der Gehäuse, wie Bodenplatten oder Deckel, halten den beschriebenen Umgebungsbedingungen in der Regel stand; insbesondere lassen sie keine Diffusion von Öl in das Innere des Gehäuses zu; dasselbe gilt auch für für diese Zwecke typischerweise verwendete Dichtungsmassen.

Problematisch bezüglich der Abdichtung sind jedoch die Übergänge beziehungsweise Zwischenräume zwischen einzelnen Teilen des Gehäuses, zum Beispiel zwischen dem Deckel und der Bodenplatte.

Ein weiteres Einfallstor für mögliche Diffusionen in das Innere des Gehäuses können zum Beispiel die Übergänge zwischen den Oberflächen von freiliegenden elektrischen Leitern und deren unmittelbarer Umgebung sein, wenn diese Leiter zur Kontaktierung der in dem Gehäuse befindlichen elektronischen Schaltung nach außerhalb des Gehäuses geführt sind.

Im Stand der Technik sind verschiedene Ansätze bekannt, welche jeweils versuchen, die Dichtigkeit zwischen Leiterbahnen und einem sie umgebendem Medium zu verbessern. Eine bekannte Möglichkeit sieht vor, die Leiter in Form von Stiften zu pressen, wobei die Stifte eine genau definierte Form mit hoher Präzision aufweisen müssen, um gegenüber dem sie umgebenden Medium abdichtbar zu sein. Eine alternative Möglichkeit sieht vor, die Leiter mit einem elastischen Werkstoff zu umgeben, der die Dichtfunktion übernimmt. Beide Lösungen sind aber nur dann technisch machbar und wirtschaftlich sinnvoll, wenn nur wenige Leiter für eine Verbindung der elektronischen Schaltung nach außerhalb des Gehäuses erforderlich sind und die Abstände zwischen den Leitern relativ groß sind.

Aus der US 5,943,558 ist ein Verfahren zur Herstellung eines luftdichten Gehäuses für einen Halbleiterchip bekannt. Die US 5,107,074 offenbart ein hermetische dichtes Gehäuse für einen Leistungshalbleiter.

Ausgehend von dem genannten Stand der Technik ist es die Aufgabe der Erfindung, eine Abdichtung für ein Gehäuse für eine elektronische Schaltung insbesondere in dem Bereich, wo elektrische Leiter zur Kontaktierung der elektronischen Schaltung durch das Gehäuse hindurchtreten, zu verbessern.

Diese Aufgabe wird durch den Gegenstand des Patentanspruchs 1 gelöst. Demnach erfolgt die Lösung durch eine einteilige Dichtung zum Abdichten eines Zwischenraums zwischen Bodenplatte und Deckel, durch den gegebenenfalls die freiliegenden elektrischen Leiter geführt sind.

Einteilig im Sinne der Erfindung meint zum einen, dass die Dichtung für den zusammenhängenden Zwischenraum nicht aus verschiedenen Teildichtungen besteht, die ihrerseits wieder Schnittstellen zueinander aufweisen. Die einteilige Dichtung selber hat unmittelbaren Kontakt zu den Oberflächen von einzelnen Teilen des Gehäuses und/oder zu den Oberflächen der elektrischen Leiter. Einteilig meint weiterhin zwangsläufig, dass die Dichtung in dem gesamten Zwischenraum aus demselben Material gebildet ist.

Der Begriff "Dichtung" wird in der Beschreibung gleichbedeutend mit sich in ihrem endgültigen chemischen und physikalischen Zustand befindlichen Dichtungsmasse verwendet. Die Dichtung bzw. Dichtungsmasse fungiert einerseits zum Abdichten; sie dient aber darüber hinaus immer auch als Klebemittel um sich selbst mit einzelnen Oberflächen des Gehäuses oder der freiliegenden elektrischen Leiter zu verbinden. Auch unter der Voraussetzung, dass die Dichtungsmasse als solche dicht ist, auch im Sinne von diffusionsdicht für zum Beispiel Öl oder Ölbestandteile, so sind die kritischen Stellen für ein eventuelles Eindringen von unerwünschten Substanzen in das Innere des Gehäuses insbesondere in den Übergängen zwischen der Dichtungsmasse und den angrenzenden Oberflächen von Gehäuseteilen oder von elektrischen Leitern zu sehen. Insofern wird die Dichtigkeit der Dichtung auch ganz wesentlich durch ihre Klebewirkung zu den angrenzenden Oberflächen bestimmt.

### Vorteile der Erfindung

Die beanspruchte einteilige Dichtung ist vorteilhafterweise so gestaltet, dass sie den Zwischenraum zwischen Bodenplatte, Deckel und gegebenenfalls auch Leitern abdichtet. Dies beinhaltet erstens eine Einzelabdichtung für jeden einzelnen Leiter, das heißt sie stellt insbesondere aufgrund ihrer Klebewirkung sicher, dass insbesondere an den Grenzflächen zwischen Leiteroberfläche und Dichtung, keine unerwünschten Substanzen in das Innere des Gehäuses eindringen können. Gleichzeitig dient sie zur elektrischen Isolierung zwischen benachbarten Leitern. Die Anzahl der elektrischen Leiter ist im Hinblick auf den Aufwand zur Realisierung der Dichtung unbeachtlich. Eine analoge Abdichtung wie an den Grenzflächen zu den Oberflächen der Leiter bewirkt die Dichtung aufgrund ihrer Klebewirkung auch an den Grenzflächen zu der Bodenplatte und dem Deckel.

Gemäß einer vorteilhaften Ausgestaltung des Gehäuses sind die Bodenplatte, der Deckel und die Leiter aus einem gleichartigen Material, insbesondere aus Metallen, gefertigt. Erfindungsgemäß gehen die Bodenplatte, der Deckel und die Leiter einen hochbeständigen Metall-Kleber-Verbund ein. Vorzugsweise sind die Bodenplatte und der Deckel aus Aluminium und sind die Leiter aus einem kupferhaltigen Werkstoff, vorzugsweise aus Kupfer oder aus einer Kupferlegierung, gefertigt. Die Verwendung gleichartiger Materialien ermöglicht es vorteilhafterweise, die Dichtungsmasse ganz gezielt im Hinblick auf eine angestrebte maximale Klebewirkung beziehungsweise maximale Dichtigkeit insbesondere im Übergangsbereich zwischen der Dichtung und dem jeweiligen angrenzenden Material zu optimieren. Eine Verwendung gleicher Materialien bietet weiterhin den Vorteil, dass sich die Bodenplatte und der Deckel jeweils in gleichem Maße thermisch ausdehnen oder zusammenziehen; auf diese Weise werden mechanische Spannungen und eventuell daraus resultierende Undichtigkeiten der Dichtung präventiv verhindert.

Bei der Verwendung unterschiedlicher Materialien für die Bodenplatte und den Deckel, was gemäß der vorliegenden Erfindung nicht grundsätzlich ausgeschlossen werden soll, muss jedoch eine lediglich suboptimale Dichtwirkung im Übergangsbereich zwischen der Dichtung und einem der Materialien in Kauf genommen werden, wenn die Dichtungsmasse im Hinblick auf eine optimale Dichtigkeit im Übergang zu dem anderen Material ausgewählt wurde.

Vorteilhafterweise sind die freiliegenden beziehungsweise blanken Leiter in einem Rahmen geführt und auf diese Weise fest zueinander positioniert. Der Rahmen ist zwischen der Bodenplatte und dem Deckel des zusammengebauten Gehäuses vorgesehen. Durch eine entsprechende geometrische Ausgestaltung dieses Rahmens ist es möglich, die Positionen und/oder Abstände von Bodenplatte, Deckel und den freiliegenden Leitern relativ zueinander bei dem zusammengebauten Gehäuse vorzugeben.

Eine besonders präzise Einstellung beziehungsweise Einhaltung der vorbestimmten relativen Abstände von Bodenplatte, Deckel oder Leitern zueinander wird dadurch erreicht, dass der Rahmen geeignet dimensionierte und positionierte Abstandhalter aufweist.

Vorteilhafterweise kann die Bodenplatte des Gehäuses eine Vertiefung zur Aufnahme von Dichtungsmasse aufweisen; auf diese Weise kann eine vergleichsweise niedrige Bauweise des Gehäuses realisiert werden.

Vorteilhafterweise weist der Rahmen im Bereich der Vertiefung der Bodenplatte eine Öffnung beziehungsweise Aussparung auf, welche zusammen mit der Bodenplatte beziehungsweise deren Vertiefung den Zwischenraum zumindest teilweise begrenzt. In diesen Zwischenraum kann dann vorzugsweise flüssige Dichtungsmasse eingebracht werden, damit sie sich möglichst in alle Verästelungen des Zwischenraumes hinein ausdehnt.

Die elektrischen Leiter sind vorzugsweise als Stanzgitterbahnen ausgebildet.

Die oben genannte Aufgabe wird weiterhin durch ein Verfahren zum Abdichten eines Gehäuses für eine elektronische Schaltung gelöst. Die Vorteile dieses Verfahrens entsprechen den oben mit Bezug auf das beanspruchte Gehäuse genannten Vorteilen. Vorteilhafte Ausgestaltungen des Verfahrens sind Gegenstand der Unteransprüche.

### Zeichnungen

Der Beschreibung sind fünf Figuren beigefügt, wobei
- Figur 1: ein erstes Ausführungsbeispiel für den Aufbau und die Abdichtung eines Gehäuses für eine elektronische Schaltung in einem Längsschnitt;
- Figur 2: den Aufbau des Gehäuses für die elektronische Schaltung gemäß der Erfindung in einer Draufsicht;
- Figur 3: ein zweites Ausführungsbeispiel für den Aufbau und die Abdichtung des Gehäuses in einem Längsschnitt;
- Figur 4: ein drittes Ausführungsbeispiel für den Aufbau und die Abdichtung des Gehäuses in einem Längsschnitt; und
- Figur 5: ein Beispiel für den Aufbau und die Abdichtung des Gehäuses in einem Bereich ohne elektrische Leiter;
veranschaulicht.

### Beschreibung von Ausführungsbeispielen

In allen Figuren bezeichnen gleiche Bezugszeichen gleiche Elemente.

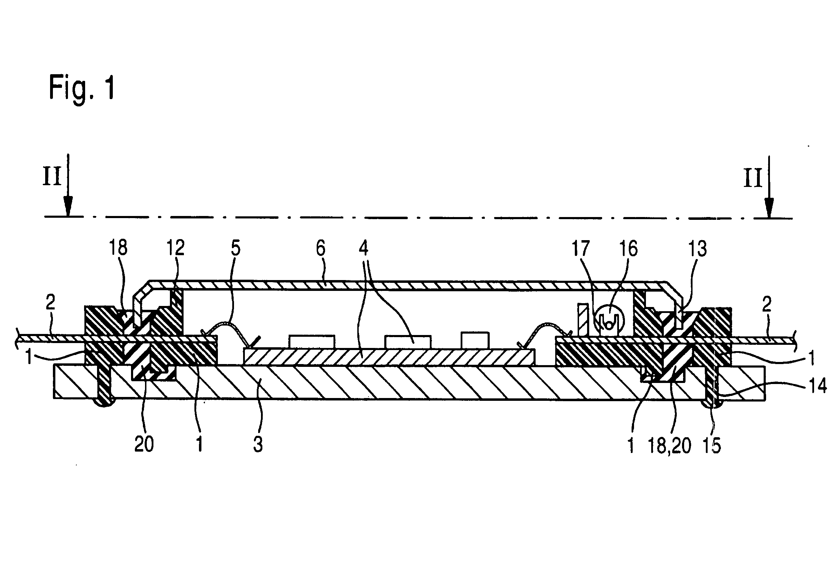

Figur 1 beschreibt ein erstes Ausführungsbeispiel für das erfindungsgemäß abgedichtete Gehäuse einer elektronischen Schaltung 4. Das Gehäuse umfasst zunächst eine Bodenplatte 3, auf welche die elektronische Schaltung 4 aufgebracht, vorzugsweise aufgeklebt ist. Die elektronische Schaltung besteht aus einem Schaltungsträger, vorzugsweise einer Low Temperature Cofired Ceramic LTCC oder einem Hybrid, der mit elektronischen Bauelementen bestückt ist. Die Bodenplatte 3 ist vorzugsweise aus Metall gebildet; sie kann dann als Kühlfläche zur Ableitung von Wärme dienen, die durch die elektronische Schaltung 4 während deren Betriebs generiert wird.

Die elektronische Schaltung 4 ist von einem Rahmen 1, vorzugsweise einem Kunststoffrahmen umgeben, in welchem elektrische Leiter 2, vorzugsweise in Form von Stanzgitterbahnen, einbettet sind. Die Bodenplatte 3 weist mindestens zwei Bohrungen 14 auf, zur Aufnahme von an den Kunststoffrahmen angespritzten Zapfen 15. Durch das Eingreifen der Zapfen 15 in die Bohrungen 14 wird der Kunststoffrahmen 1 relativ zu der Bodenplatte 3 und zu der fest mit der Bodenplatte 3 verbundenen elektronischen Schaltung 4 in der Ebene der Bodenplatte 3 positioniert. Zur Fixierung des Rahmens 1 auch in einer Richtung vertikal zu der Bodenplatte 3 kann an jeden Zapfen 15 ein Nietkopf angeformt sein, zum Beispiel mittels eines thermischen Prozesses (zum Beispiel durch Heiß-Kalt-Verstemmung). Die Kontaktierung der elektronischen Schaltung 4 mit den elektrischen Leitern 2 erfolgt durch Bonds 5.

Wenn die elektrischen Leiter 2 ein stückweit in das Innere des Gehäuses hineinragen, bevor sie mit der elektronischen Schaltung verbondet werden, ermöglicht dies vorteilhafterweise den Einbau zusätzlicher elektronischer Bauelemente in das Innere des Gehäuses neben den Bauelementen, welche die elektronische Schaltung 4 repräsentieren. Diese zusätzlichen Bauelemente lassen sich innerhalb des Gehäuses direkt an die elektrischen Leiter 2 schweißen und durch diese nach außerhalb des Gehäuses oder auch weiter nach innen zu der elektronischen Schaltung 4 kontaktieren. In Figur 1 ist beispielhaft solch ein zusätzliches Bauelement in Form eines Drahtbauelementes 16 in einen aus den Stanzgitterbahnen geformten Gabelkontakt 17 eingeschweißt dargestellt. Mit dem Vorsehen der beschriebenen, ausreichend weit in das Innere des Gehäuses hineinragenden Leiterbahnen 2 ist es vorteilhafterweise möglich, teure Fläche auf dem Schaltungsträger einzusparen beziehungsweise Bauelemente verwenden zu können, welche nicht auf dem Schaltungsträger befestigt oder kontaktiert werden können.

Zum Verschließen des Gehäuses dient ein Deckel 6, welcher auf Abstandhaltern 12 ruht, welche zum Beispiel an dem Kunststoffrahmen 1 an geeigneter Stelle vorgesehen sind. Zum Abdichten des Gehäuses wird eine vorzugsweise flüssige Dichtungsmasse 20 in eine durch die Bodenplatte 3 und den Kunststoffrahmen 1 begrenzte Nut 18 eingefüllt. Das Einfüllen der Dichtungsmasse erfolgt vorzugsweise unter Vakuum, um eine Blasenbildung innerhalb der Dichtungsmasse und eine damit einhergehende Verschlechterung von deren Dichtigkeit zu verhindern. Der Pegel, bis zu welchem die Dichtungsmasse in die Nut 18 eingefüllt wird, wird vorzugsweise so gewählt, dass ein senkrechter Abschnitt 13 des Deckels 6 ausreichend tief in die Dichtungsmasse eintaucht und von dieser umschlossen wird. Ausreichend tief bedeutet in diesem Zusammenhang, dass eine ausreichende Fläche zur Einwirkung der Dichtungsmasse auf diesen Abschnitt 13 des Deckels verbleibt, um auf diesen eine Haltekraft in Form einer Klebewirkung ausüben zu können, so dass der Deckel aufgrund dieser Klebekraft sicher in seiner Position gehalten wird. Nachdem sich die zuvor flüssige Dichtungsmasse verfestigt hat beziehungsweise nicht mehr bearbeitungsfähig ist, bildet sie eine einteilige Dichtung.

Für die Dichtigkeit des Gehäuses ist insbesondere die Haftung der Dichtungsmasse an den sie umgebenden Teilen, das heißt insbesondere an der Bodenplatte, den elektrischen Leitern 2 und dem Deckel relevant. Zur Erzielung einer optimalen Dichtigkeit des Gehäuses ist es deshalb empfehlenswert, wenn nicht nur die Leiter 2, sondern auch die Bodenplatte 3 und auch der Deckel 6 des Gehäuses alle aus dem gleichen Material, vorzugsweise Metall gefertigt sind. Dies hätte den Vorteil, dass dann die Dichtungsmasse im Hinblick auf eine maximale Klebewirkung zu dem einheitlich verwendeten Material, also beispielsweise Metall, ausgewählt werden kann. Bei der Verwendung von unterschiedlichen Materialien für die Bodenplatte 3 und den Deckel 6, zum Beispiel bei Verwendung einer Bodenplatte aus Metall und einem Deckel 6 aus Kunststoff, muss eine lediglich suboptimale Dichtigkeit beziehungsweise Haftung an einem der Materialien in Kauf genommen werden, wenn die Dichtungsmasse auf das jeweils andere Material hin optimal ausgewählt wurde.

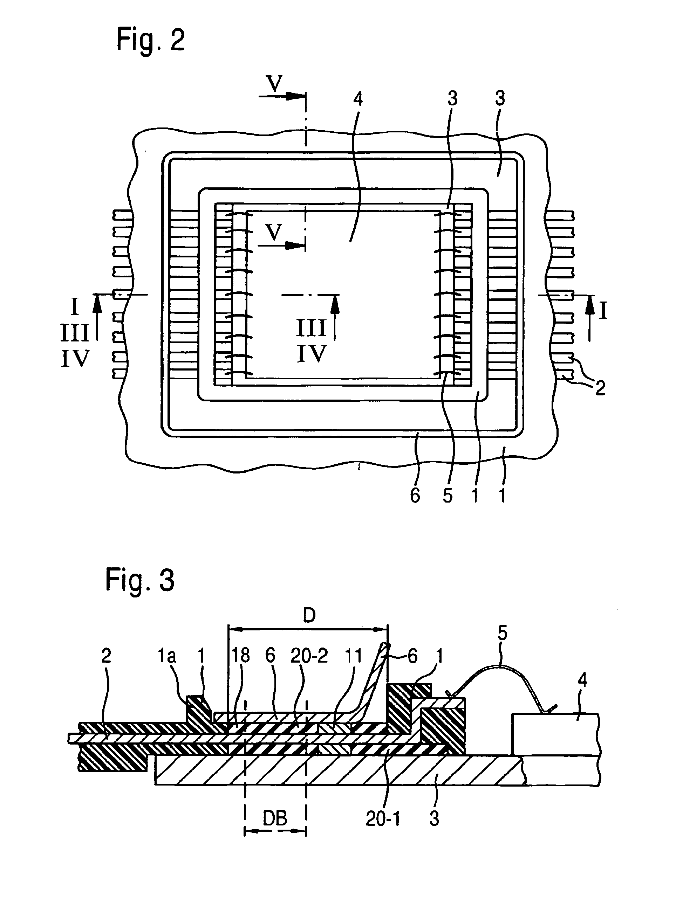

Figur 2 zeigt eine Draufsicht auf das in Figur 1 gezeigte Gehäuse. Die Bezugszeichen in Figur 2 repräsentieren die in Figur 1 erläuterten Komponenten des Gehäuses mit den gleichen Bezugszeichen. Besonders erwähnt sei lediglich, dass, wie in Figur 2 ersichtlich, nicht nur ein Leiter, sondern typischerweise eine Mehrzahl von elektrischen Leitern 2 durch das Gehäuse hindurchtreten, um die elektronische Schaltung 4 mit der Außenwelt zu verbinden.

Figur 3 zeigt ein zweites Ausführungsbeispiel für den Aufbau und die Abdichtung des Gehäuses. Im Unterschied zu dem in Figur 1 gezeigten ersten Ausführungsbeispiel eignet sich das in Figur 3 gezeigte zweite Ausführungsbeispiel insbesondere zur Verwendung von Dichtungsmasse mit einer im Vergleich zu dem ersten Ausführungsbeispiel höheren Viskosität. Die höhere Viskosität erlaubt nun kein Vergießen mehr der Dichtungsmasse wie bei dem ersten Ausführungsbeispiel, sondern stattdessen die Auftragung der Dichtungsmasse in Form von Dichtungsmassenraupen zunächst auf der Bodenplatte 3. In das so gebildete erste Dichtungsmassenbett 20-1 wird der Rahmen 1 eingedrückt, welcher durch seine spezifische geometrische Ausgestaltung insbesondere den Abstand d zwischen der Bodenplatte 3 und dem Leiter 2 vorgibt. In Figur 3 würde der freiliegende Leiter 2 grundsätzlich über einen relativ großen Bereich D frei schweben, was bei einer ebenfalls metallischen Ausbildung der Bodenplatte 3 die Gefahr einer Kurzschlussbildung in sich bergen würde. Ein Kurzschluss würde dann eintreten, wenn dieser frei schwebende Leiter 2 mit der metallischen Bodenplatte 3 in Kontakt käme. Um einen solchen Kurzschluss zu verhindern, sieht das zweite Ausführungsbeispiel einen Abstandhalter 11 vor, der zum einen zwischen der Bodenplatte 3 und dem Leiter 2 ausgebildet it. Der Abstandhalter 11 ist darüber hinaus auch oberhalb des Leiters 2 ausgebildet, um später, wenn der Deckel 6 geschlossen ist, auch einen ansonsten möglichen Kurzschluss zwischen dem Deckel 6 und dem Leiter 2 zu verhindern. Der Zwischenraum zwischen dem Rahmen 1 und dem Stützelement 11 oberhalb der Leiterbahnen 2 wird vor dem Verschließen des Gehäuses mit Dichtungsmasse, wieder zum Beispiel in Form von Dichtungsmassenraupen, aufgefüllt. Das so gebildete zweite Dichtungsmassenbett 20-2 kann aufgetragen werden, bevor das erste Dichtungsmassenbett 20-1 ausgetrocknet beziehungsweise nicht mehr bearbeitungsfähig ist. Insbesondere zwischen den einzelnen Leitern 2 treffen das erste und das zweite Dichtungsmassenbett 20-1, 20-2 zusammen und verbinden sich dort zu einer einteiligen Dichtung. Vorzugsweise wird das zweite Dichtungsmassenbett auch auf eine Oberseite der Stützstelle 11 sowie auf eine Oberseite des Rahmens 1 im Bereich des Anschlags 1a ausgedehnt. In dieses Dichtungsmassenbett 20-2 wird dann der Deckel 6 eingedrückt, allerdings natürlich nicht, bevor nicht die elektrischen Leiter 2 mit der elektronischen Schaltung verbondet wurden. Der Anschlag 1a gewährleistet zusammen mit der Stützstelle 11 einen konstanten Abstand des Deckels 6 zu dem Leiter 2. Überschüssige Dichtungsmasse kann in einen Ringraum zwischen Deckel 6 und dem Kunststoffrahmen 1 aufsteigen. Insgesamt entsteht so bei dem zweiten Ausführungsbeispiel ein Dichtbereich DB.

Die Stützstelle 11 ist vorzugsweise genau wie der Rahmen 1 aus Kunststoff ausgebildet und in diesen integriert.

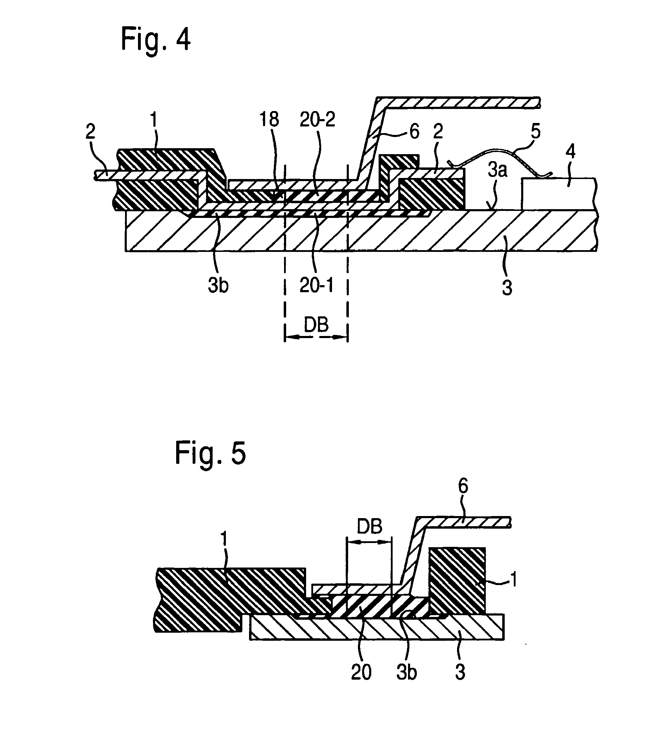

Figur 4 zeigt ein drittes Ausführungsbeispiel für die konstruktive Ausgestaltung des Zwischenbereiches zwischen Deckel 6, Leiterbahn 2 und Bodenplatte 3. Bei dem dritten Ausführungsbeispiel besteht die Forderung, die gesamte Bauhöhe des Gehäuses möglichst gering zu halten. Der Leiter 2 ist deshalb im Bereich zwischen dem Deckel 6 und der Bodenplatte 3 in seinem Verlauf vorzugsweise auf die Höhe der Oberfläche 3a der Bodenplatte 3 abgesenkt. Um in diesem Bereich eine direkte Kontaktierung des Leiters 2 mit der Bodenplatte 3, das heißt einen elektrischen Kurzschluss zu verhindern, weist die Bodenplatte 3 in diesem Bereiche eine Vertiefung 3b auf. Diese Vertiefung 3b hat genau wie die Stützstelle 11 in dem zweiten Ausführungsbeispiel eine Doppelfunktion: Beide gewährleisten eine vorbestimmte Dicke für die Dichtungsmasse in diesem Bereich und sie verhindern gleichzeitig einen Kurzschluss zwischen den Leitern 2 und der Bodenplatte 3, wenn die Bodenplatte 3 metallisch ausgebildet ist.

In allen drei genannten Ausführungsbeispielen ist die durch den Rahmen 1 beziehungsweise den Abstandhalter 11 und die Bodenplatte 3 gebildete Nut 18 zur Aufnahme der Dichtungsmasse vorzugsweise in Form eines geschlossenen Linienzuges rund um die elektronische Schaltung 4 ausgebildet. Diese Nut 18 wird dabei lediglich punktuell von dem Leiter 2 durchkreuzt.

Grundsätzlich gibt es je nach Anzahl der Leiter 2 eine Vielzahl von Bereichen, in denen diese Nut nicht von dem Leiter 2 durchkreuzt wird. Der Längsschnitt durch einen solchen Bereich, in Figur 2 angedeutet durch den Schnitt V-V, ist in Figur 5 dargestellt. Figur 5 unterscheidet sich von der Ausgestaltung des Zwischenbereiches zwischen der Bodenplatte 3 und dem Deckel 6 von dem in Figur 4 gezeigten dritten Ausführungsbeispiel lediglich dadurch, dass der Leiter 2, wie gesagt, die Nut 18 nicht durchkreuzt.

Allen in den Figuren 1, 3 - 5 gezeigten Ausführungsbeispielen der Erfindung ist gemeinsam, dass der Dichtbereich DB für das Gehäuse immer durch eine Metall-Dichtungsmasse-Verbindung realisiert wird, wenn der Deckel 6 und die Bodenplatte 3 jeweils aus Metall gebildet sind. Unter der Voraussetzung, dass die Dichtungsmasse selber insbesondere für Umgebungsbedingungen innerhalb eines Getriebes dicht ist und insbesondere keine Diffusionen von Öl in das Innere des Gehäuses zulässt, verbleiben als möglicherweise undichte Bereiche die Übergänge zwischen der Dichtungsmasse selber und den Oberflächen der angrenzenden Teile des Gehäuses. Bei den in den Figuren 1, 3 und 4 gezeigten drei Ausführungsbeispielen zeigt sich in vertikaler Richtung folgender Schichtaufbau: Bodenplatte 3 - Dichtungsmasse 20 - Leiter 2 - Dichtungsmasse 20 - Deckel 6. Für den in Figur 5 gezeigten Längsschnitt ergibt sich eine Schichtenfolge von: Bodenplatte 3 - Dichtungsmasse 20 - Deckel 6. Alleine die Haftung der Dichtungsmasse in diesen Übergängen zu der Bodenplatte, dem Leiter und dem Deckel ist letzten Endes verantwortlich für die Dichtigkeit des Gehäuses. Diese kann dadurch optimiert werden, dass nicht nur der Leiter 2, sondern auch die Bodenplatte 3 und der Deckel 6 aus einem gleichartigen Material, vorzugsweise einem Metall ausgebildet sind, weil dann die Dichtungsmasse im Hinblick auf eine optimale Haftung beziehungsweise Klebewirkung an dieses gleichartige Material ausgewählt werden kann. Bei den drei beschriebenen Ausführungsbeispielen ist die Haftung der Dichtungsmasse an dem Rahmen 1 für die Güte der Dichtigkeit ohne Belang. Die Dichtungsmasse wird deshalb vorteilhafterweise speziell im Hinblick auf eine optimale Dichtigkeit im Übergang auf Metall ausgewählt. Die Ausbildung von Bodenplatte 3 und Deckel 6 aus einem gleichen Material, vorzugsweise Aluminium, hat weiterhin den Vorteil, dass sich die Bodenplatte 3 und der Deckel 6 bei Erwärmung des Gehäuses, insbesondere bei Betrieb der elektronischen Schaltung, in gleicher Weise ausdehnen. Im Unterschied zu einem theoretisch auch möglichen Materialmix, das heißt zum Beispiel der Kombination eines Kunststoffdeckels mit einer metallischen Bodenplatte, kann durch die Verwendung gleicher Materialien eine Verbiegung der Bodenplatte und eine Rissbildung zwischen Deckel 6 und Bodenplatte 3 verhindert werden. Sowohl die Verbiegung der Bodenplatte 3 wie auch die Rissbildung würden möglicherweise zu einer Undichtigkeit des Gehäuses, zu einer mangelnden Wärmeabfuhr oder zu einem Bruch des Schaltungsträgers führen, was jeweils zwangsläufig den Ausfall des gesamten Steuergerätes zur Folge hätte.

## Patentansprüche

1. Gehäuse für eine elektronische Schaltung (4), insbesondere für ein Steuergerät, wobei die Schaltung (4) eine Mehrzahl von elektrischen Kontakten aufweist, die über individuelle elektronische Leiter (2) nach außerhalb des Gehäuses geführt sind, und wobei das Gehäuse eine Bodenplatte (3) und einen Deckel (6) sowie mindestens eine Dichtung zwischen der Bodenplatte (3) und dem Deckel (6) umfasst, wobei die Dichtung (20) einteilig ausgebildet ist zum Abdichten eines Zwischenraums zwischen der Bodenplatte (3) und dem Deckel (6), durch den die freiliegenden elektrischen Leiter (2) geführt sind.
**dadurch gekennzeichnet, dass**
die freiliegenden Leiter (2) in einem Rahmen (1) geführt und fest zueinander positioniert sind, wobei der Rahmen (1) zwischen der Bodenplatte (3) und dem Deckel (6) angeordnet ist und durch seine konkrete Ausgestaltung die Positionen und/oder die Abstände von Bodenplatte (3), Deckel (6) und den freiliegenden Leitern (2) relativ zueinander bei dem geschlossenen Gehäuse definiert.

2. Gehäuse nach Anspruch 1, **dadurch gekennzeichnet, dass** die Bodenplatte (3), der Deckel (6) und die Leiter (2) aus einem gleichartigen Material, vorzugsweise aus Metall, gefertigt sind.

3. Gehäuse nach Anspruch 2, **dadurch gekennzeichnet, dass** die Bodenplatte (3) und der Deckel (6) aus Aluminium gefertigt sind.

4. Gehäuse nach Anspruch 2 oder 3, **dadurch gekennzeichnet, dass** die Leiter (2) aus einem kupferhaltigen Werkstoff, vorzugsweise aus Kupfer oder aus einer Kupferlegierung, gefertigt sind.

5. Gehäuse nach einem der vorangegangenen Ansprüche, **dadurch gekennzeichnet, dass** die Bodenplatte (3) und/oder der Deckel (6) oder der Rahmen (1) Abstandshalter (11) und/oder Anschläge (1a) aufweisen, welche jeweils so ausgebildet und positioniert sind, dass sie die Einhaltung eines vorbestimmten Abstandes des Leiters (2) zu der Bodenplatte (3) oder zu dem Deckel (6) bei geschlossenem Gehäuse gewährleisten.

6. Gehäuse nach einem der vorangegangenen Ansprüche, **dadurch gekennzeichnet, dass** die Bodenplatte (3) eine Vertiefung (3b) zur Aufnahme von einem Teil der Dichtung aufweist.

7. Gehäuse nach einem der vorangegangenen Ansprüche, **dadurch gekennzeichnet, dass** der Rahmen (1) eine Aussparung (14) aufweist, welche zusammen mit der Bodenplatte (3) den Zwischenraum zumindest teilweise begrenzt.

8. Gehäuse nach einem der vorangegangenen Ansprüche, **dadurch gekennzeichnet, dass** der elektrische Leiter (2) als Stanzgitterbahn ausgebildet ist.

9. Verfahren zum Abdichten eines Gehäuses für eine elektronische Schaltung (4), insbesondere für ein Steuergerät, wobei die Schaltung (4) eine Mehrzahl von elektrischen Kontakten aufweist, die über individuelle elektrische Leiter (2) nach außerhalb des Gehäuses geführt sind, und wobei das Gehäuse eine Bodenplatte (3), einen Deckel (6) und eine Dichtung zwischen der Bodenplatte (3) und dem Deckel (6) umfasst, **gekennzeichnet durch** folgenden Schritt:
- Ausbilden der Dichtung in einteiliger Form in einem Zwischenraum zwischen der Bodenplatte (3) und dem Deckel (6), **durch** den die freiliegenden elektrischen Leiter (2) geführt sind, wobei die freiliegenden Leiter (2) in einem Rahmen (1) geführt und fest zueinander positioniert werden, wobei der Rahmen (1) zwischen der Bodenplatte (3) und dem Deckel (6) angeordnet wird und **durch** seine konkrete Ausgestaltung die Positionen und/oder die Abstände von Bodenplatte (3), Deckel (6) und den freiliegenden Leitern (2) relativ zueinander bei dem geschlossenen Gehäuse definiert.

10. Verfahren nach Anspruch 9, **dadurch gekennzeichnet, dass** das Ausbilden der Dichtung (20) während eines Zusammenbaus des Gehäuses durch Ausführen der folgenden aufeinander folgenden Schritte erfolgt:
- Auftragen eines ersten Dichtungsmassenbettes (20-1) auf die Oberfläche (3a) der Bodenplatte (3) in der Umgebung der elektronischen Schaltung (4) auf der Bodenplatte (3),
- Aufsetzen eines Rahmens (1) mit den Leitern (2) auf das erste Dichtungsmassenbett (20-1), vorzugsweise so, dass ein Teil der Dichtungsmasse (20-1) zwischen den freiliegenden Leitern (2) hervorquillt,
- Auffüllen eines zweiten Teils des Zwischenraumes oberhalb der Leiter (2) mit Dichtungsmasse zum Bilden eines zweiten Dichtungsmassenbettes (20-2), und
- Einlegen des Deckels (6) des Gehäuses in das zweite Dichtungsmassenbett (20-2).

11. Verfahren nach Anspruch 10, **dadurch gekennzeichnet, dass** der Deckel (6) des Gehäuses erst in das zweite Dichtungsmassenbett (20-2) eingelegt wird, nachdem die Leiter (2) mit der elektronischen Schaltung (4) verbondet wurden.

12. Verfahren nach Anspruch 9, **dadurch gekennzeichnet, dass** das Ausbilden der Dichtung (20) während eines Zusammenbaus des Gehäuses durch Ausführen der folgenden Schritte erfolgt:
- Aufbringen eines Rahmens (1), in welchem die Leiter (2) geführt und fest zueinander positioniert sind, an vorbestimmter Position auf die Bodenplatte (3) und Verbonden der Leiter (2) mit der elektronischen Schaltung (4),
- Einfüllen von flüssiger Dichtungsmasse in eine durch die Oberfläche der Bodenplatte (3) und einer Aussparung in dem Rahmen (1) gebildete Nut (18), und
- Schließen des Gehäuses durch geeignetes Positionieren des Deckels (6) auf Abstandhaltern (12) und/oder Anschlägen (1a) des Rahmens (1), wobei der Rand (13) des Deckels (6) in die Dichtungsmasse (20) in der Nut (18) eintaucht.

## Claims

1. Housing for an electronic circuit (4), in particular for a control device, with the circuit (4) having a plurality of electrical contacts which are routed to outside the housing by means of individual electronic conductors (2), and with the housing comprising a base plate (3) and a cover (6) and also at least one seal between the base plate (3) and the cover (6), with the seal (20) being of integral design for the purpose of sealing off an intermediate space between the base plate (3) and the cover (6), through which intermediate space the exposed electrical conductors (2) are routed, **characterized in that** the exposed conductors (2) are routed in a frame (1) and are positioned fixedly in relation to one another, with the frame (1) being arranged between the base plate (3) and the cover (6) and, on account of its specific configuration, defining the positions and/or the distances of the base plate (3), cover (6) and the exposed conductors (2) in relation to one another when the housing is closed.

2. Housing according to Claim 1, **characterized in that** the base plate (3), the cover (6) and the conductors (2) are produced from a similar material, preferably from metal.

3. Housing according to Claim 2, **characterized in that** the base plate (3) and the cover (6) are produced from aluminium.

4. Housing according to Claim 2 or 3, **characterized in that** the conductors (2) are produced from a copper-containing material, preferably from copper or from a copper alloy.

5. Housing according to one of the preceding claims, **characterized in that** the base plate (3) and/or the cover (6) or the frame (1) have spacers (11) and/or stops (1a) which are each formed and positioned such that they ensure the conductor (2) is kept at a predetermined distance from the base plate (3) or from the cover (6) when the housing is closed.

6. Housing according to one of the preceding claims, **characterized in that** the base plate (3) has a recess (3b) for accommodating a portion of the seal.

7. Housing according to one of the preceding claims, **characterized in that** the frame (1) has a cutout (14) which, together with the base plate (3), at least partially bounds the intermediate space.

8. Housing according to one of the preceding claims, **characterized in that** the electrical conductor (2) is in the form of a leadframe track.

9. Method for sealing off a housing for an electronic circuit (4), in particular for a control device, with the circuit (4) having a plurality of electrical contacts which are routed to outside the housing by means of individual electrical conductors (2), and with the housing comprising a base plate (3), a cover (6) and a seal between the base plate (3) and the cover (6), **characterized by** the following step:
- forming the seal integrally in an intermediate space between the base plate (3) and the cover (6), through which intermediate space the exposed electrical conductors (2) are routed, with the exposed conductors (2) being routed in a frame (1) and being positioned fixedly in relation to one another, with the frame (1) being arranged between the base plate (3) and the cover (6) and, on account of its specific configuration, defining the positions and/or the distances of the base plate (3), cover (6) and the exposed conductors (2) in relation to one another when the housing is closed.

10. Method according to Claim 9, **characterized in that** the seal (20) is formed during assembly of the housing by executing the following successive steps:
- applying a first sealing compound bed (20-1) to the surface (3a) of the base plate (3) in the area surrounding the electronic circuit (4) on the base plate (3),
- placing a frame (1) with the conductors (2) onto the first sealing compound bed (20-1), preferably such that some of the sealing compound (20-1) wells up between the exposed conductors (2),
- filling a second part of the intermediate space above the conductors (2) with sealing compound in order to form a second sealing compound bed (20-2), and
- inserting the cover (6) of the housing into the second sealing compound bed (20-2).

11. Method according to Claim 10, **characterized in that** the cover (6) of the housing is first inserted into the second sealing compound bed (20-2) after the conductors (2) have been bonded to the electronic circuit (4).

12. Method according to Claim 9, **characterized in that** the seal (20) is formed during assembly of the housing by executing the following steps:
- applying a frame (1), in which the conductors (2) are routed and are positioned fixedly in relation to one another, at a predetermined position to the base plate (3) and bonding the conductors (2) to the electronic circuit (4),
- filling liquid sealing compound into a groove (18) which is formed by the surface of the base plate (3) and a cutout in the frame (1), and
- closing the housing by suitable positioning of the cover (6) on spacers (12) and/or stops (1a) of the frame (1), with the rim (13) of the cover (6) dipping into the sealing compound (20) in the groove (18).

## Revendications

1. Boîtier pour un circuit électronique (4), en particulier pour un appareil de commande, le circuit (4) présentant une pluralité de contacts électriques qui sont amenés à l'extérieur du boîtier par des conducteurs (2) électriques individuels, et le boîtier comprenant une plaque de fond (3) et un couvercle (6) ainsi qu'au moins un élément d'étanchéité entre la plaque de fond (3) et le couvercle (6), l'élément d'étanchéité (20) étant réalisé d'une seule pièce pour étancher un espace entre la plaque de fond (3) et le couvercle (6) à travers lequel sont guidés les conducteurs (2) électriques nus,
**caractérisé en ce que**
les conducteurs (2) nus sont guidés dans un cadre (1) et positionnés de façon fixe les uns par rapport aux autres, le cadre (1) étant disposé entre la plaque de fond (3) et le couvercle (6) et définissant, grâce à sa conformation concrète, les positions et/ou les distances de la plaque de fond (3), du couvercle (6) et des conducteurs (2) nus les uns par rapport aux autres lorsque le boîtier est fermé.

2. Boîtier selon la revendication 1,
**caractérisé en ce que**
la plaque de fond (3), le couvercle (6) et les conducteurs (2) sont fabriqués à partir d'un matériau de même type, de préférence en métal.

3. Boîtier selon la revendication 2,
**caractérisé en ce que**
la plaque de fond (3) et le couvercle (6) sont en aluminium.

4. Boîtier selon la revendication 2 ou 3,
**caractérisé en ce que**
les conducteurs (2) sont fabriqués en un matériau cuivreux, de préférence en cuivre ou un alliage de cuivre.

5. Boîtier selon l'une quelconque des revendications précédentes,
**caractérisé en ce que**
la plaque de fond (3) et/ou le couvercle (6) ou le cadre (1) présente des écarteurs (11) et/ou des butées (1a) qui sont chacun conformés et positionnés pour assurer le respect d'une distance prédéterminée du conducteur (2) par rapport à la plaque de fond (3) et au couvercle (6) si le boîtier est fermé.

6. Boîtier selon l'une quelconque des revendications précédentes,
**caractérisé en ce que**
la plaque de fond (3) présente un creux (3b) pour recevoir une partie de l'élément d'étanchéité.

7. Boîtier selon l'une quelconque des revendications précédentes,
**caractérisé en ce que**
le cadre (1) présente un évidement (14) qui, conjointement avec la plaque de fond (3), délimite l'espace au moins en partie.

8. Boîtier selon l'une quelconque des revendications précédentes,
**caractérisé en ce que**
le conducteur électrique (2) présente la forme de piste de grillage estampé.

9. Procédé pour étancher un boîtier pour un circuit électronique (4), en particulier pour un appareil de commande, le circuit (4) présentant une pluralité de contacts électriques qui sont amenés à l'extérieur du boîtier par des conducteurs (2) électriques individuels, et le boîtier comprenant une plaque de fond (3) et un couvercle (6) ainsi qu'un élément d'étanchéité entre la plaque de fond (3) et le couvercle (6),
**caractérisé par** l'étape suivante :
- réalisation de l'élément d'étanchéité d'une seule pièce dans un espace entre la plaque de fond (3) et le couvercle (6), à travers lequel sont guidés les conducteurs (2) électriques nus, les conducteurs (2) électriques nus étant guidés dans un cadre (1) et positionnés de façon fixe les uns par rapport aux autres, le cadre (1) étant disposé entre la plaque de fond (3) et le couvercle (6) et définissant, grâce à sa conformation concrète, les positions et/ou les distances de la plaque de fond (3), du couvercle (6) et des conducteurs (2) nus les uns par rapport aux autres lorsque le boîtier est fermé.

10. Procédé selon la revendication 9,
**caractérisé en ce que**
la réalisation du joint d'étanchéité s'effectue pendant un assemblage du boîtier en exécutant les étapes successives suivantes :
- application d'un premier lit de masse d'étanchéité (20-1) sur la surface (3a) de la plaque de fond (3) dans l'environnement du circuit électronique (4) sur la plaque de fond (3),
- mise en place d'un cadre (1) avec les conducteurs (2) sur le premier lit de masse d'étanchéité (20-1), de préférence de telle sorte qu'une partie de la masse d'étanchéité (20-1) jaillisse d'entre les conducteurs (2) nus,
- remplissage d'une deuxième partie de l'espace au-dessus des conducteurs (2) avec la masse d'étanchéité pour former un deuxième lit de masse d'étanchéité (20-2), et
- insertion du couvercle (6) du boîtier dans le deuxième lit de masse d'étanchéité (20-2).

11. Procédé selon la revendication 19,
**caractérisé en ce que**
l'on n'insère le couvercle (6) du boîtier dans le deuxième lit de masse d'étanchéité (20-2) qu'après avoir mis en contact les conducteurs (2) avec le circuit électronique (4).

12. Procédé selon la revendication 9,
**caractérisé en ce que**
la réalisation de l'étanchéité (20) s'effectue pendant un assemblage du boîtier en exécutant les étapes suivantes :
- mise en place d'un cadre (1) dans lequel les conducteurs (2) sont guidés et positionnés de façon fixe les uns par rapport aux autres, dans une position prédéterminée sur la plaque de fond (3) et mise en contact des conducteurs (2) avec le circuit électronique (4),
- versement d'une masse d'étanchéité liquide dans une rainure (18) formée par la surface de la plaque de fond (3) et un évidement dans le cadre (1), et
- fermeture du boîtier par un positionnement approprié du couvercle (6) sur des écarteurs (12) et/ou des butées (1a) du cadre (1), le bord (13) du couvercle (6) étant plongé dans la masse d'étanchéité (20) dans la rainure (18).
